# EUROPEAN PATENT APPLICATION

(11) **EP 4 790 442 A1**
(43) Date of publication of application: **12.08.2026**
(21) Application number: 26156509.7
(22) Date of filing: 05.02.2026
(51) Int. Cl.: G01R 33/34

(54) **SYSTEMS AND METHODS FOR SUPPORTING A FLEXIBLE RECEIVE COIL**

(30) Priority: 10.02.2025 US 202519049606
(71) Applicant: FUJIFILM Corporation, Tokyo 106-8620 (JP)
(72) Inventor: SZPAK, Anthony, Brecksville, OH, 44141 (US); RICHARD, Mark, Solon, OH, 44139 (US); COOK, Gina, Independence, OH, 44131 (US); NAPIER, Christophor, Tallmadge, OH, 44278 (US)
(74) Representative: Dehns Germany Partnerschaft mbB

(57) **Abstract**

An adjustable support for a flexible receive coil including a plurality of links. Each link can include a cross bar, a first side bar coupled to a first-end portion of the cross bar and a second side bar coupled to a second-end portion of the cross bar. The first link can be rotatably coupled to the second link. A first leading-end portion of first link is rotatably coupled to a first trailing-end portion of the second link such that the first leading-end mating surface of the first link engages the first trailing-end mating surface of the second link. A second leading-end portion of first link is rotatably coupled to a second trailing-end portion of the second link such that the second leading-end mating surface of the first link engages the second trailing-end mating surface of the second link.

## Description

### Background

### 1. Field of Disclosure

The disclosed subject matter is directed to systems and methods for supporting a flexible receive coil for magnetic resonance imaging (MRI) systems.

### 2. Description of Related Art

MRI is a medical diagnostic imaging technique used to diagnose many types of medical conditions. In MRI systems, three electromagnetic fields interact to produce images of anatomy, for example, human anatomy. The three fields include:
1) Main magnetic field - a static, spatially homogenous field to polarize spins of various nuclei within the body, making a net positive population available for detection. The static field must be very homogenous for imaging. For a horizontal field MRI system, the static magnetic field is oriented along the patient axis (head-to-foot) of a patient laying on a horizontal table. This axis is typically referred to as the Z-direction.
2) Gradient magnetic field - a spatially varying field that can create a difference in the z-component of the magnetic field across the imaging region. Additionally, the gradient magnetic field is switched at audio frequencies to encode spin positions and generate contrast. Typically, three spatially varying magnetic fields are created along the orthogonal axes to encode spins in three directions.
3) Radiofrequency (RF) magnetic field - a magnetic field operating at tens of MHz, used to add energy to spins, to detect the associated signals, and generate contrast. The direction of the RF field is orthogonal to the main magnetic field.

MRI systems can include a plurality of hardware components that work in conjunction with specialized software to produce the required magnetic fields and MRI images. MRI systems can include a main magnet, which can generate the main magnetic field, B₀. The main magnet of MRI systems can generate horizontal (aligned with the long axis (head-to-foot) of a patient laying on a horizontal table) or vertical (aligned from back to front of a patient laying on a horizontal table) magnetic fields. Most commonly, the magnetic field generated by the main magnet is 1.5 tesla or 3.0 tesla, but both lower and higher field strengths are also used clinically. Accordingly, the resulting physics for horizontal and vertical systems can be very different.

Within the volume defined by the main magnet can be a gradient magnetic coil assembly. The gradient magnetic coil assembly typically includes three gradient axes to encode spins in three spatial dimensions. The gradient coils can produce substantially linear spatially varying magnetic fields within the imaging volume that are coincident with the direction of the main magnetic field but can vary along the three orthogonal directions (X, Y, Z) of the Cartesian coordinate system. Exemplary gradient coil systems are provided in U.S. Patent No. 7,482,809, which is incorporated by reference in its entirety.

An RF transmit / receive assembly can be disposed within the volume defined by the gradient magnetic coil assembly, and can generate the RF magnetic field as well as detect resulting signals from the excited tissue. For some scanning procedures, the RF transmit / receive assembly performs both operations of transmit and receive. In many scanning procedures, however, the RF transmit / receive assembly performs only the transmit operation.

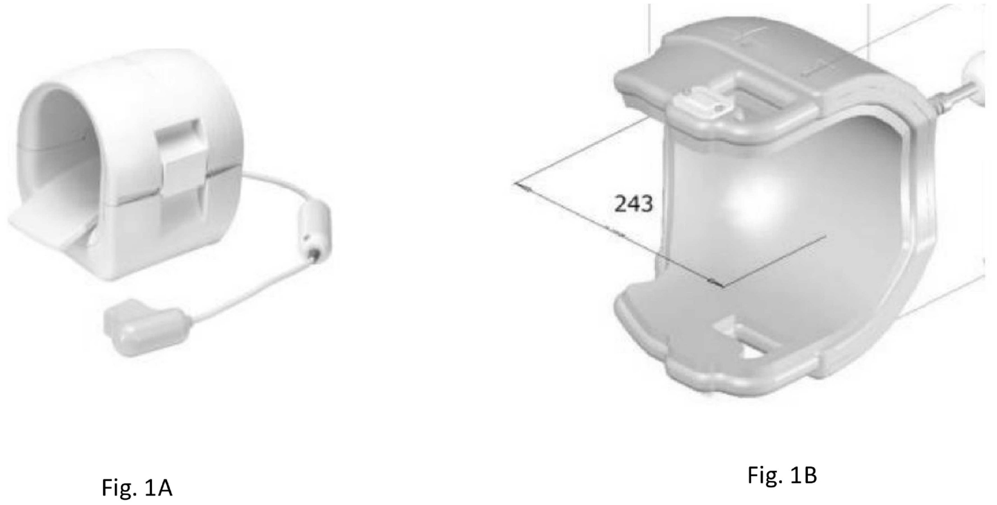

Commonly, a dedicated RF receive assembly is disposed within the volume of the RF transmit/receive assembly, to receive the RF magnetic field from the excited tissues excited by the transmit signal which is emitted by the RF transmit / receive assembly. The RF receive assembly, (also referred to herein as "RF receive coils" or "receive coils") can be made from rigid plastic or similar material, and can be sized and shaped to fit the anatomy being imaged. For example, FIG. 1A shows a knee receive coil that has a tube-shaped circular shell with a removable upper part to position the patient. As another example, FIG. 1B shows a shoulder receive coil can include a rigid case, which can look like a clam shell, to encompass the shoulder or it can include a circular loop through which the patient's arm can be passed.

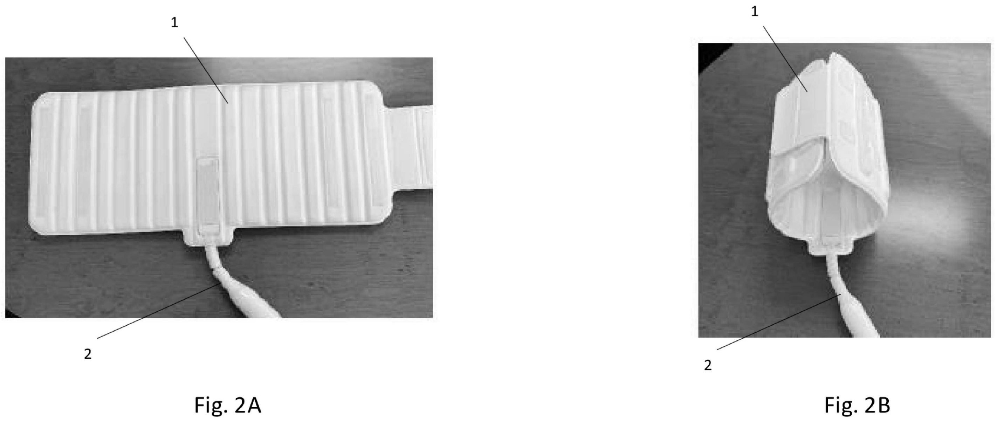

Flexible coils, which can be wrapped around the anatomy of interest, can also be used as receive coils. Some flexible coils, sometimes called "general purpose coils" (and referred to herein as "flexible coils" or "coils") can be used to fulfill a plurality of imaging applications, such as imaging of the knee, foot, ankle, shoulder, wrist, elbow, torso, pelvis, or neck. An exemplary flexible coil 1 is shown laid flat in FIG. 2A and wrapped in FIG. 2B. The flexible coils 1 can be wrapped around the anatomy of interest or placed over the anatomy to be imaged. Such flexible coils 1 can be used in isolation, or used together with one or more other receive coils, such as a spine receive coil or a head receive coil. Flexible coils 1 can include a cable 2 extending therefrom which carries the signal received in the coil to the MRI system, such that an image can be generated.

A challenge practitioners face is that flexible coils 1 do not hold a particular shape. For example, when imaging a knee, it is not possible to position the coil 1 in a semi-circle before the knee is positioned. Accordingly, practitioners must do one of the following approaches: First, lay the coil 1 flat on the table before the patient arrives. The technologist must then pull out the end of the coil 1 from the non-target knee and wrap both ends of the coil 1 around the target knee. This can be difficult, for example, for heavy patients. Alternatively, a practitioner can have the patient lay on the patient table and then lift the target knee to slide the flexible coil 1 under the knee. However, lifting a patient's knee can be a challenge, for example, for heavy patients or patients with significant injuries. For each of these approaches, the coil 1 is typically closed in a loop and secured with a hook-and-loop fastener (e.g., Velcro^{®}) or similar fasteners, such that the entirety of the knee is surrounded by the receive coil elements. Shoulder imaging can be even more challenging. For example, one end of the flexible coil 1 can be placed under the patient's shoulder, while the remainder of the coil 1 is wrapped around the shoulder and onto the patient's chest. To properly place the coil 1, the patient first lies on the table, and the practitioner must then lift the patient to place a portion of the flexible coil 1 under the patient. Straps can be used to hold the coil 1 in place. Additionally or alternatively, patient positioning pads can be used. However, these are typically anatomy specific and require the practitioner to select the appropriate pads and then position them in such a way to hold the anatomy and/or coil in the proper position.

Accordingly, there is a need for a device to support a flexible coil, which can hold the coil in an appropriate shape close to the anatomy of interest and which is compatible with use in an MRI environment.

### Summary

The purposes and advantages of the disclosed subject matter will be set forth in and apparent from the description that follows, as well as will be learned by the practice of the disclosed subject matter. Additional advantages of the disclosed subject matter will be realized and attained by the methods and systems particularly pointed out in the written description and claims hereof, as well as the appended figures.

To achieve these and other advantages and in accordance with the purpose of the disclosed subject matter, as embodied and broadly described, the disclosed subject matter is directed to systems and methods for supporting a flexible receive coil. For example, an adjustable support for a flexible receive coil is provided. The adjustable support can include a plurality of links including at least a first link, a second link, and a third link. Each link includes a cross bar having a first-end portion and a second-end portion, a first side bar coupled to the first-end portion of the cross bar and a second side bar coupled to the second-end portion of the cross bar. The first side bar includes a first leading-end portion including a first leading-end mating surface, and a first trailing-end portion including a first trailing-end mating surface. The second side bar includes a second leading-end portion including a second leading-end mating surface, and a second trailing-end portion including a second trailing-end mating surface. The cross bar, first side bar, and second side bar define a coil-engagement surface. The first link is rotatably coupled to the second link. The first leading-end portion of first link is rotatably coupled to the first trailing-end portion of the second link such that the first leading-end mating surface of the first link engages the first trailing-end mating surface of the second link, and the second leading-end portion of first link is rotatably coupled to the second trailing-end portion of the second link such that the second leading-end mating surface of the first link engages the second trailing-end mating surface of the second link. The first link and the second link define an adjustable angle therebetween.

In accordance with the disclosed subject matter, the coil-engagement surface of each link can include a coil attachment feature. The coil attachment feature can include a first side of a hook-and-loop fastener configured to engage a second side of a hook-and-loop fastener of a flexible receive coil.

The first leading-end portion of the first link can be rotatably coupled to the first trailing-end potion of the second link by a first ball-and-detent configuration and the second leading-end portion of the first link can be rotatably coupled to the second trailing-end portion of the second link by a second ball-and-detent configuration. As another example, the first leading-end portion of the first link can be rotatably coupled to the first trailing-end potion of the second link by a friction fit and the second leading-end portion of the first link can be rotatably coupled to the second trailing-end portion of the second link by a friction fit. The first leading-end mating surface of the first link can include a plurality of gears configured to engage a plurality of gears disposed on the first trailing-end mating surface of the second link and the second leading-end mating surface of the first link can include a plurality of gears configured to engage a plurality of gears disposed on the second trailing-end mating surface of the second link.

In accordance with the disclosed subject matter a support base can be configured to receive at least one link. The support base can include a latch configured to releasably engage at least one cross bar. Additionally or alternatively, the support base further can include at least one cable-receiving groove.

Each link can be a non-ferromagnetic material. The second link can be rotatably coupled to the third link such that the first leading-end portion of the second link is rotatably coupled to the first trailing-end portion of the third link such that the first leading-end mating surface of the second link engages the first trailing-end mating surface of the third link, the second leading-end portion of the second link is rotatably coupled to the second trailing-end portion of the third link such that the second leading-end mating surface of the second link engages the second trailing-end mating surface of the third link, and the second link and the third link define an adjustable angle therebetween.

The adjustable support for a flexible receive coil can include a first end link having a cross bar, a first side bar and a second side bar. The cross bar can include a first-end portion and a second-end portion. The first side bar can be coupled to the first end portion of the cross bar and include a first leading-end portion including a first leading-end mating surface and a first trailing-end portion. The second side bar can be coupled to the second end portion of the cross bar and include a second leading-end portion including a second leading-end mating surface and a second trailing-end portion. The end link can be rotatably coupled to the first link such that the first leading-end portion of the end link is rotatably coupled to the first trailing-end portion of the first link such that the first leading-end mating surface of the end link engages the first trailing-end mating surface of the first link, and the second leading-end portion of the end link is rotatably coupled to the second trailing-end portion of the first link such that the second leading-end mating surface of the end link engages the second trailing-end mating surface of the first link.

### Brief Description of the Figures

In the drawings:
FIG. 1A shows a knee receive coil having a tube-shaped circular shell.
FIG. 1B shows a shoulder receive coil having a rigid case.
FIGs. 2A-2B show a flexible coil in a flat position and a wrapped position, respectively.
FIG. 3 shows a flexible support in accordance with the disclosed subject matter.
FIG. 4A shows the flexible support of FIG. 3 in an L-shape.
FIG. 4B shows the flexible support of FIG. 3 in a U-shape.
FIG. 5 show a link of the flexible support of FIG. 3.
FIG. 6 shows a flexible support utilizing Hirth joints, in accordance with the disclosed subject matter.
FIG. 7 shows a link of the flexible support of FIG. 6.
FIGs. 8A and 8B show a flexible support utilizing Hirth joints and a configuration wherein applying tension on a tether releases the Hirth joints.
FIGs. 9A and 9B show a flexible support utilizing Hirth joints and a configuration wherein releasing tension on a tether releases the Hirth joints.
FIG. 10 shows a flexible support utilizing asymmetrical Hirth joints, in accordance with the disclosed subject matter.
FIG. 11 shows a link of the flexible support of FIG. 10.
FIGs. 12A-12B show cut-away views of the asymmetrical Hirth joints of the flexible support of FIG. 10.
FIG. 12C shows the asymmetrical Hirth joint of the flexible support of FIG. 10 without a cap.
FIG. 13 shows the flexible support of FIG. 10.
FIGs. 14A-14B show the asymmetrical teeth of the Hirth joints of the flexible support of FIG. 10.
FIG. 15 shows a base in accordance with the disclosed subject matter.
FIG. 16 shows a bottom view of the base of FIG. 15.
FIG. 17A shows a cut-away view of the flexible support of FIG. 3 received within the base of FIG. 15.
FIG. 17B shows a cut-away view of the flexible support of FIG. 10 received within a base, in accordance with the disclosed subject matter.
FIGs. 18A-D show a flexible support received within a base in a U-shape (FIG. 18A) and supporting a flexible coil in a U-shape (FIGs. 18B-D).
FIGs. 19A-D show a flexible support received within a base in a C-shape (FIG. 19A) and supporting a flexible coil in a C-shape (FIGs. 19B-D).
FIG. 20 shows a flexible coil positioned for imaging a knee.
FIGs. 21A and 21B show a flexible coil positioned for imaging a shoulder.
FIG. 22 shows a flexible coil positioned for imaging a foot.

### Detailed Description

Reference will now be made in detail to various exemplary embodiments of the disclosed subject matter, exemplary embodiments of which are illustrated in the accompanying drawings. As used in the description and the appended claims, the singular forms, such as "a," "an," "the," and singular nouns, are intended to include the plural forms as well, unless the context clearly indicates otherwise. In accordance with the disclosed subject matter, systems and methods for supporting a flexible receive coil are provided. For example, an adjustable support for a flexible receive coil is provided. The adjustable support can include a plurality of links including at least a first link, a second link, and a third link. Each link having a cross bar having a first-end portion and a second-end portion, a first side bar coupled to the first-end portion of the cross bar and a second side bar coupled to the second-end portion of the cross bar. The first side bar includes a first leading-end portion including a first leading-end mating surface, and a first trailing-end portion including a first trailing-end mating surface. The second side bar includes a second leading-end portion including a second leading-end mating surface, and a second trailing-end portion including a second trailing-end mating surface. The cross bar, first side bar, and second side bar define a coil-engagement surface. The first link is rotatably coupled to the second link. The first leading-end portion of the first link is rotatably coupled to the first trailing-end portion of the second link such that the first leading-end mating surface of the first link engages the first trailing-end mating surface of the second link, and the second leading-end portion of the first link is rotatably coupled to the second trailing-end portion of the second link such that the second leading-end mating surface of the first link engages the second trailing-end mating surface of the second link. The first link and the second link define an adjustable angle therebetween.

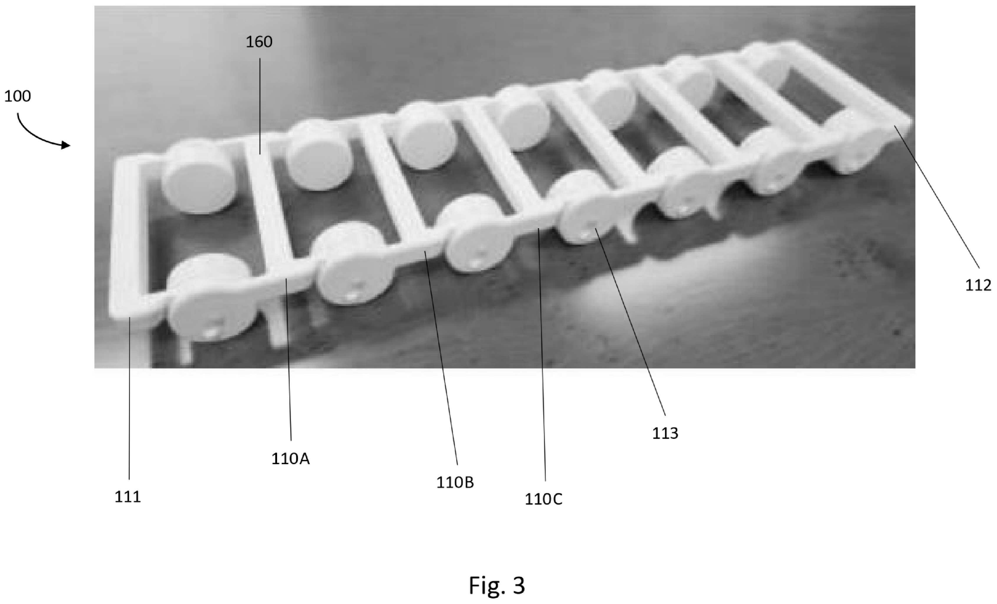

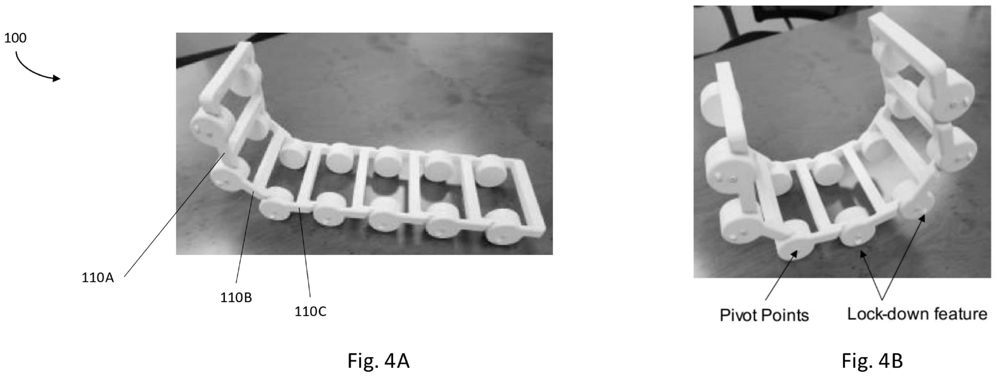

Referring to FIGs. 3-5 for purpose of illustration and not limitation, an adjustable support 100 in accordance with the disclosed subject matter is provided. The adjustable support 100 (referred to herein as "adjustable support," "flexible support," or "support") can include a plurality of links 110 (e.g., 110A, 110B, 110C). Each link 110 (e.g., 110A, 110B, 110C) can be rotatably coupled to an adjacent link 110 (e.g., 110A, 110B, 110C). For example, as shown in FIG. 3, link 110B is rotatably coupled to link 110A and link 110C. Each link 110 (e.g., 110A, 110B, 110C) can be independently rotatably coupled to each adjacent link, which can allow the support 100 to be configured into a suitable shape, such as a line (e.g., FIG. 3), L-shape (e.g., FIG. 4A), U-shape (e.g., FIG. 4B), C-shape, S-shape, or other suitable shape. The coupling between links 110 can be configured to not rotate freely, but require some force from a user to rotate the links 110 relative to one another. Because a force from the user is required to change the shape of the support 100, the support 100 can remain in the shape formed by the user until the user changes the shape again. This allows the support 100 to operate as an exo-skeleton for a flexible coil 1 and be placed into a useful shape by the user for supporting a flexible coil 1.

Adjustable support 100 can include any suitable number of links 110, for example, 4 links, 5 links, 6 links, 7 links, 8 links, 9 links, or 10 or more links. Each link 110 can include a cross bar 120, a first side bar 130, and a second side bar 140. The cross bar 120 can include a first-end portion 121 and a second-end portion 122. The first side bar 130 can be coupled to the first-end portion 121 of the cross bar 120, and the second side bar 140 can be coupled to the second-end portion 122 of the cross bar 120. The first side bar 130 can include a first leading-end portion 131 including a leading-end mating surface 132, and a first trailing-end potion 133 including a trailing-end mating surface 134. Likewise, the second side bar 140 can include a second leading-end portion 141 including a leading-end mating surface 142, and a second trailing-end portion 143 including a trailing-end mating surface 144. Although described with a certain number of cross bars and side bars, any suitable number of either could be used. For example, links can include one cross bar and one side bar, two cross bars and one side bar, or two cross bars and two side bars.

A top surface of the link 110, defined by top surfaces of the cross bar 120, first side bar 130, and second side bar 140, can be a coil-engagement surface 160 (FIG. 3). The coil-engagement surface 160 can include a coil attachment feature, such as one side of a hook-and-loop fastener. A second side of the hook-and-loop fastener can be disposed on the coil 1 for attachment to the support 100. Although described as a hook-and-loop fastener, any suitable attachment feature can be used.

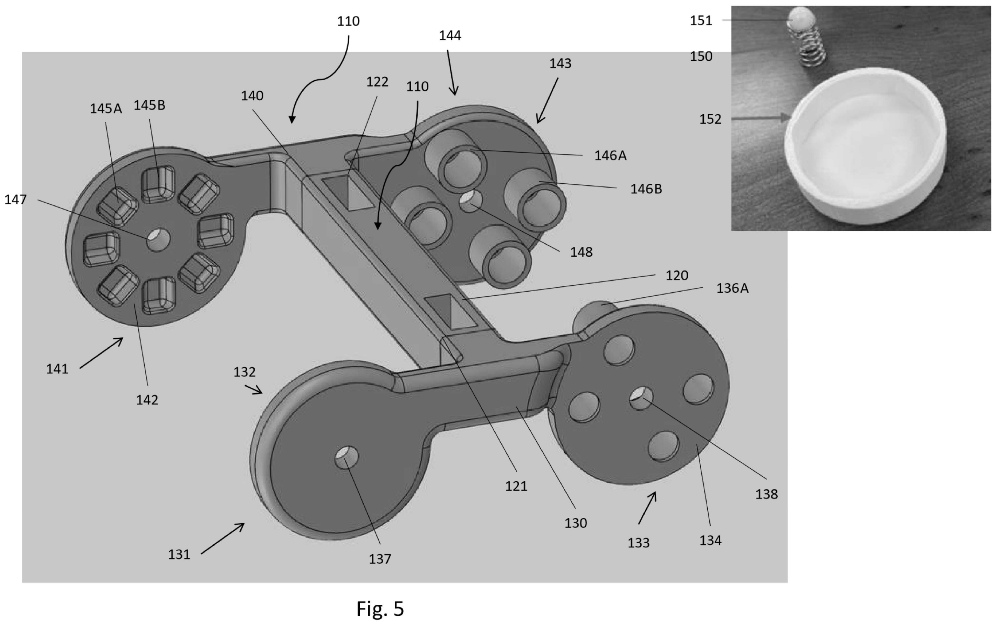

Links 110 can be rotatably coupled to an adjacent link 110 at pivot points 113. For example, the pivot points 113 can include the leading-end mating surfaces (132, 142) of the link 110 coupled to the trailing-end mating surfaces (134, 144) of an adjacent link 110. The pivot points 113 can use any suitable connection which provides the movable, but rigid connection described above. For example, a ball and detent engagement can be used. The leading-end mating surfaces 132, 142 can include detents 135 (e.g., 135A, 135B (not shown)) and 145 (e.g., 145A, 145B), respectively. Detents 135 (e.g., 135A, 135B) are not visible due to the perspective of FIG. 5, but can be disposed on the leading-end mating surface 132 having the same shape and arrangement of detents 145 (e.g., 145A, 145B) that are disposed on the leading-end mating surface 142. Leading-end mating surfaces 132, 142 can also include axis holes 137, 147. Trailing-end mating surfaces 134, 144 can include ball-and-spring receiving slots 136 (e.g., 136A) and 146 (e.g., 146A, 146B). Trailing-end mating surfaces 134, 144 can also include axis holes 138, 148. Figure 5 shows 8 detents 135, 145, and four ball-and-spring receiving slots 136, 146, however, any suitable number of either can be used. A spring 150 and ball 151 can be provided in each of the ball-and-spring receiving slots 136, 146, and a cap 152 can be provided.

To assemble adjacent links 110, the leading-end mating surfaces 132, 142 of a first link 110, can be aligned with the trailing-end mating surface 134, 144 of the second link 110, respectively, such that the axis holes 137, 147 of the first link 110 are aligned with corresponding axis holes 138, 148 of the second link 110. A first nut and bolt (not shown) or other suitable fastener can be used with the first bolt extending through the axis holes 137 and 138, and a second nut and bolt (not shown) or other suitable fastener can be used with the second bolt extending through the axis holes 147 and 148 to fix the two links 110 together. A ball 151 and spring 150 can be placed in each ball-and-spring receiving slot 136, 146, such that the ball extends toward detents 135, 145. Cap 152 can be placed over the ball-and-spring receiving slots 136, 146 to hold the balls 151 and springs 150 in place. In such a configuration, the balls 151 will engage detents 135, 145 to provide a movable, but rigid connection between links 110. Although ends of the link 110 are described as leading and trailing, any feature described above can be provided on either end of link 110 to provide a moveable, but rigid connection.

In accordance with the disclosed subject matter, end links 111, 112 can be provided. End links 111, 112 can be similar to link 110, but the side bars can be provided with only a trailing edge (and corresponding features), such as link 111 or only a leading edge (and corresponding features), such as link 112.

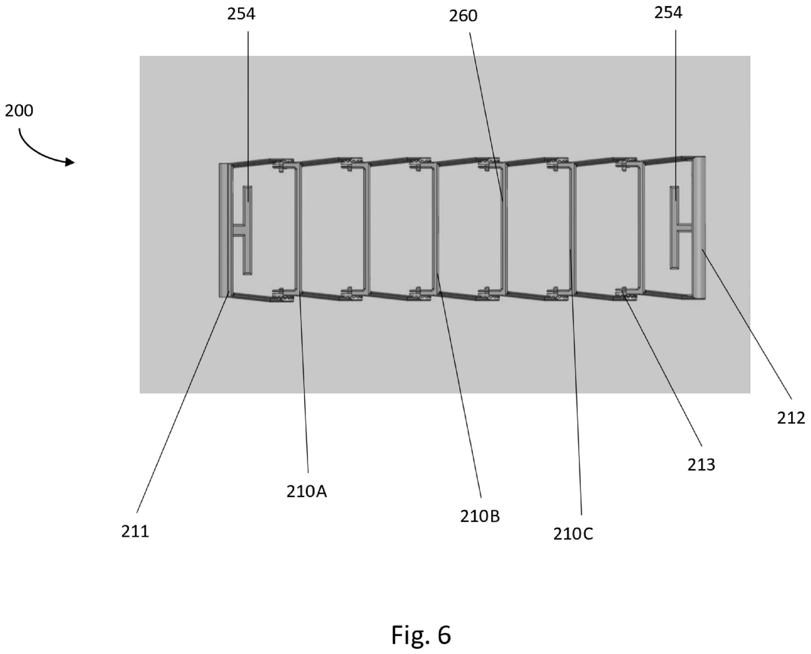

As another example, adjacent links can be coupled at pivot points using a face gear concept. Referring to FIGs. 6-9B for purpose of illustration, and not limitation, adjustable support 200 (referred to herein as "flexible support," "adjustable support," or "support") is provided. In support 200, links 210 (e.g., 210A, 210B, 210C) can be locked or released to pivot freely at pivot points 213. The lock is achieved using interlocking face gears, such as a Hirth joint. The pivot points 213 can be pushed together to lock links 210 together and can be separated to unlock motion. The support 200 can include links 210 that can all be locked/unlocked in one action. This can be accomplished by transmitting motion to all joints through a string or cable. To operate effectively, the string or cable must pass through the axis of the pivots to ensure that the changing angle of the links does not change the length of the string, which could cause certain joints to engage or disengage.

Links 210 can include a cross bar 220, a first side bar 230, and a second side bar 240. A top surface of the link, defined by the cross bar 220, first side bar 230, and second side bar 240, can be a coil-engagement surface 260, which can include the features described above with respect to coil-engagement surface 160. The cross bar 220 can include a first-end portion 221 and a second-end portion 222. The first side bar 230 can be coupled to the first-end portion 221 of the cross bar 220, and the second side bar 240 can be coupled to the second-end portion 222 of the cross bar 220. The first side bar 230 can include a first leading-end portion 231 including a leading-end mating surface 232, and a first trailing-end potion 233 including a trailing-end mating surface 234. Likewise, the second side bar 240 can include a second leading-end portion 241 including a leading-end mating surface 242, and a second trailing-end portion 243 including a trailing-end mating surface 244. Links 210 can be rotatably coupled to an adjacent link 210 at pivot points 213. For example, the pivot points 213 can include the leading-end mating surfaces (232, 242) of the link 210 coupled to the trailing-end mating surfaces (234, 244) of an adjacent link 210. A Hirth joint can be formed between leading-end mating surface 232 of a first link 210 and trailing-end mating surface 234 of an adjacent link, and a Hirth joint can be formed between leading-end mating surface 242 of a first link 210 and trailing-end mating surface 244 of an adjacent link. A first tether 253 can extend along each of the first side bars 230, coupling each of the pivot points 213 on the first side, and a second tether 253 can extend along each of the second side bars 240, coupling each of the pivot points 213 on the second side.

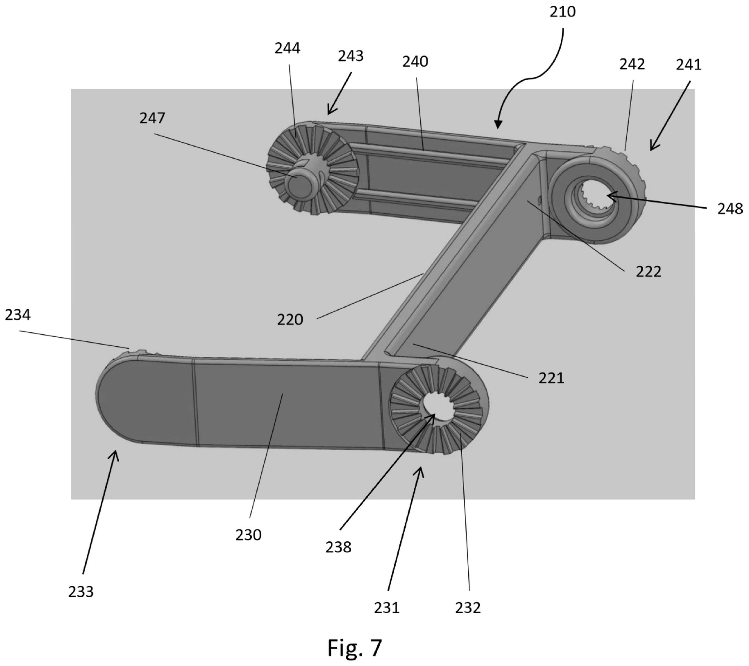

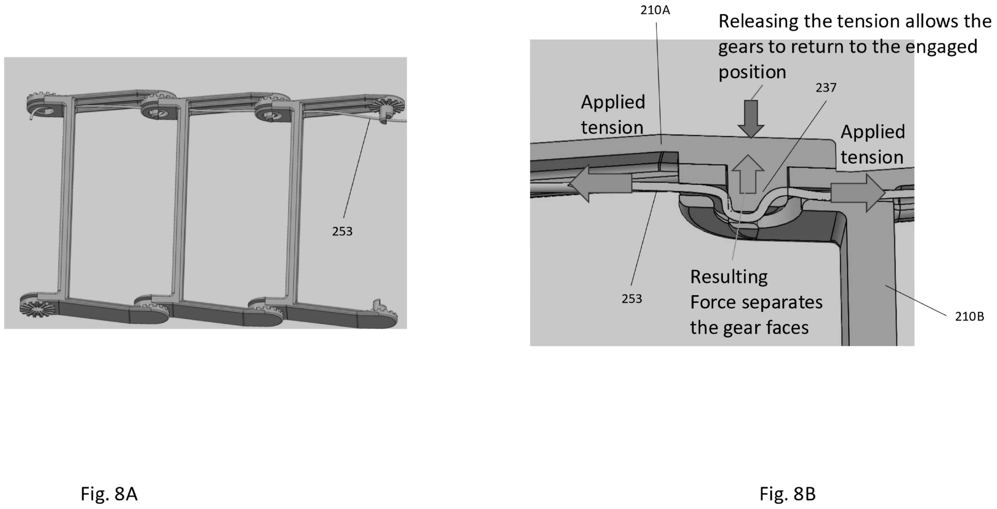

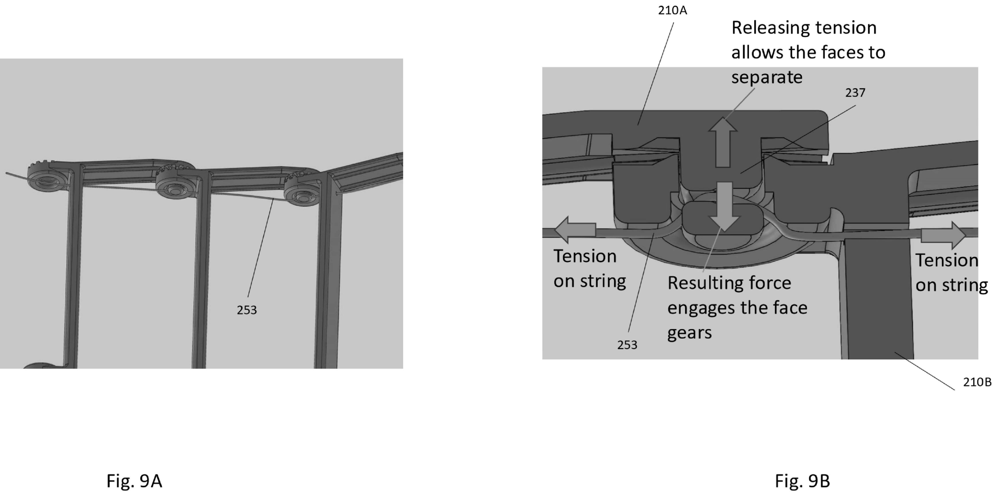

The trailing-end mating surfaces 234, 244 can include a tether lock 237, 247 that can be configured to receive tether 253, for example, through a center thereof. Tether lock 237 is not visible in FIG. 7 due to the perspective of FIG. 7, but can be disposed on the trailing-end mating surface 234 having the same shape and arrangement of tether lock 247 that is disposed on the trailing-end mating surface 244. The tether lock 237, 247 can extend through a respective opening 238, 248 in the leading-end mating surfaces 232, 242. The tether locks 237, 247, openings 238, 248, and tether 253 can be arranged such that additional tension on the tether 253 causes the leading-end mating surfaces 232, 242 and the trailing-end mating surfaces 234, 244 to be forced apart, releasing the Hirth joint and allowing rotation (FIGs. 8A and 8B). As another example, the tether locks 237, 247, openings 238, 248, and tether 253 can be arranged such that tension on the tether 253 holds the Hirth joint engaged, and releasing tension on the tether 253 causes the leading-end mating surfaces 232, 242 and the trailing-end mating surfaces 234, 244 to be forced apart, releasing the Hirth joint and allowing rotation (FIGs. 9A and 9B). The tether 253 can pass through the axis of the pivot points 213 to ensure that the changing angle between links 210 does not change the length of the tether 253, thereby preventing increasing tension on the tether 253 which can cause the Hirth joints to engage or disengage.

In accordance with the disclosed subject matter, end links 211, 212 can be provided. End links 211, 212 can be similar to link 210, but the side bars can be provided with only a trailing edge (and corresponding features), such as link 211 or only a leading edge (and corresponding features), such as link 212. End links 211, 212 can include release triggers 254, which can be coupled to the tethers 253 and can increase or decrease tension on the tethers 253, as necessary, to release the pivot points 213 when activated by a user.

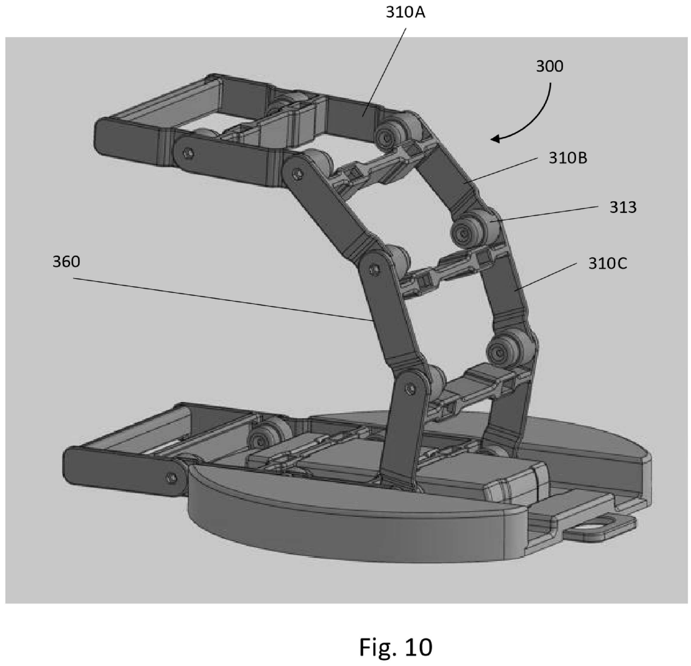

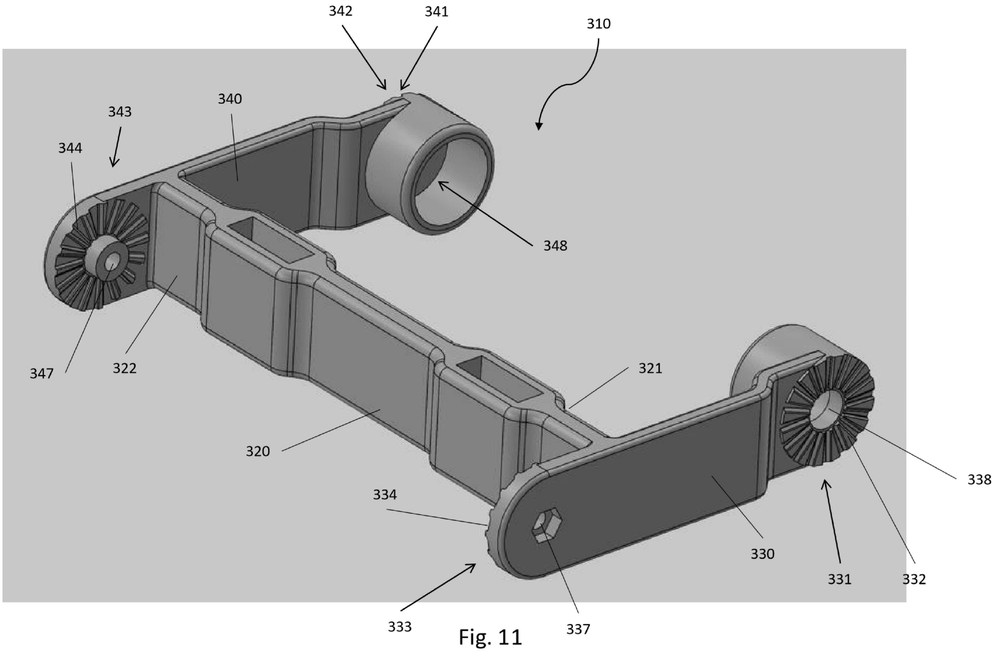

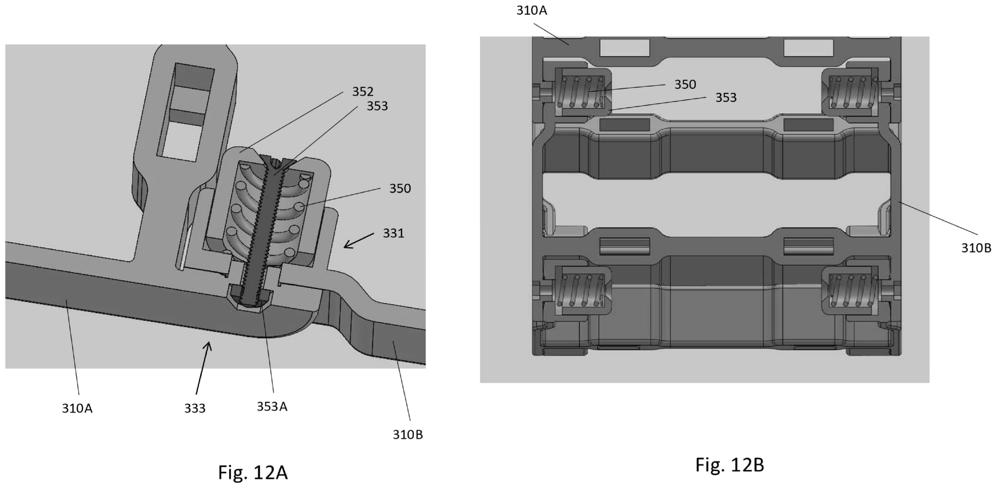

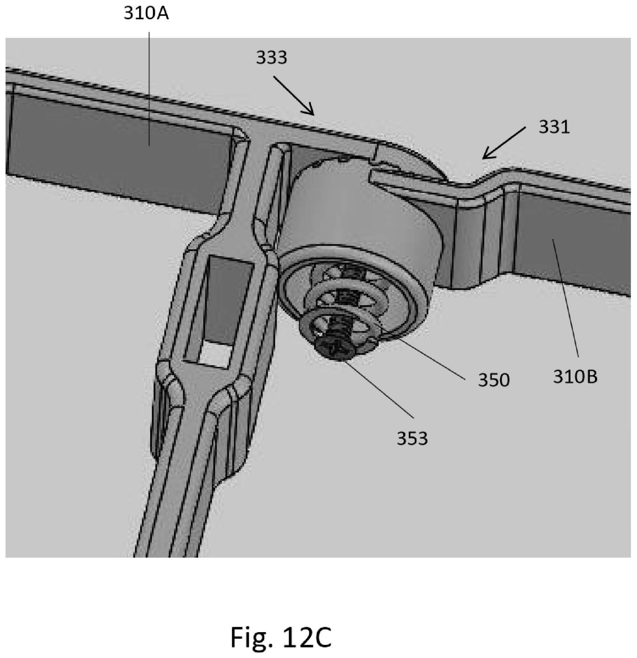

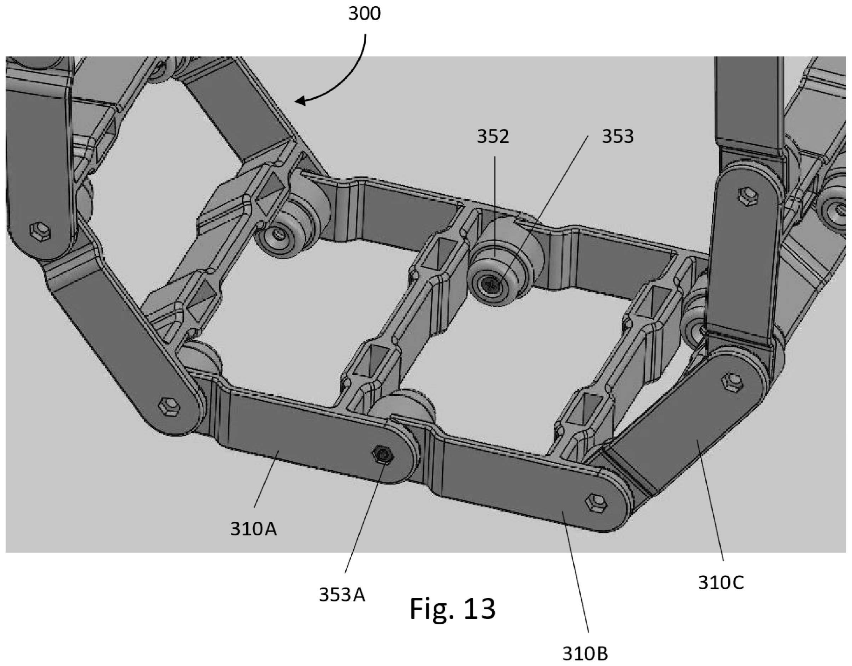

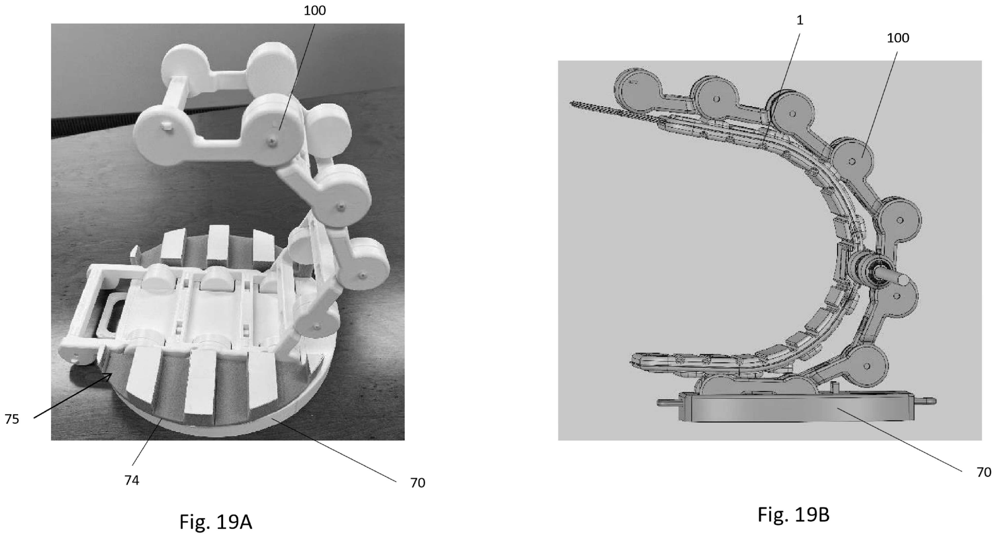

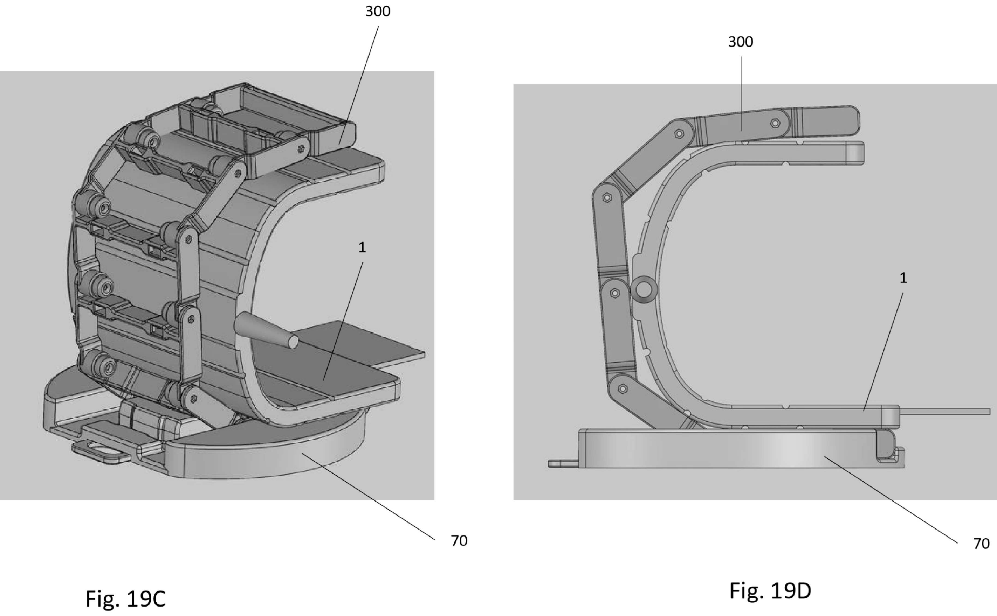

Notably, it can be beneficial for the support to provide an ability to easily move the coil 1 close to the patient anatomy. However, during use, the support should not allow the coil 1 to freely move away from the patient anatomy, as it can be important for the coil 1 to remain close to the patient anatomy for the duration of the scan. Therefore, it can be beneficial for the support to easily move inwards, while requiring more force to move outwards. For example, when the coil 1 is in a C-shape (see e.g., FIGs. 19A-D), it can be desirable that minimal force be required to close the C-shape further, but more force be required to open the C-shape wider, so that the support does not open during the scan due to patient motion or vibration.
Accordingly, as another example, adjacent links can be coupled by a spring and bolt, and a modified Hirth joint can be utilized. Such a configuration can make closing the support easier, while making opening the support harder, and can also make the joints smaller in diameter. Referring to FIGs. 10-14B for purpose of illustration, and not limitation, adjustable support 300 (referred to herein as "flexible support," "adjustable support," or "support") is provided. In support 300, links 310 (e.g., 310A, 310B, 310C) can engage one another using a modified Hirth joint at pivot points 313.

Links 310 can include a cross bar 320, a first side bar 330, and a second side bar 340. A top surface of the link, defined by the cross bar 320, first side bar 330, and second side bar 340, can be a coil engagement surface 360, which can include the features described above with respect to coil-engagement surface 160. The cross bar 320 can include a first-end portion 321 and a second end portion 322. The first side bar 330 can be coupled to the first-end portion 321 of the cross bar 320, and the second side bar 340 can be coupled to the second-end portion 322 of the cross bar 320. The first side bar 330 can include a first leading-end portion 331 including a leading-end mating surface 332, and a first trailing-end portion 333 including a trailing-end mating surface 334. Likewise the second side bar 340 can include a second leading-end portion 341 including a leading-end mating surface 342, and a second trailing-end portion 343 including a trailing-end mating surface 344. Links 310 can be rotatably coupled to an adjacent link 310 at pivot points 313. For example, the pivot points 313 can include the leading-end mating surfaces (332, 342) of the link 310 coupled to the trailing-end mating surface (334, 344) of an adjacent link 310. A Hirth joint can be formed between the leading-end mating surface 332 of a first link 310 and trailing-end mating surface 334 of an adjacent link 310, and a Hirth joint can be formed between leading-end mating surface 342 of a first link 310 and trailing-end mating surface 344 of an adjacent link. Leading-end mating surfaces 332, 342 can also include axis holes 338, 348. Trailing-end mating surfaces 334, 344 can also include axis holes 337, 347.

To connect two links 310, a bolt 353 can be passed through the axis holes 337 and 338, and through the center of a spring 350 and a second bolt 353 can be passed through axis holes 347 and 348, and through the center of a spring 350 to fix the two links 310 together. A nut 353A can be received within a form-fitting cut out (e.g., a hexagon) and can be tightened against the bolt 353. A cap 352 can contain and cover the spring 350. The spring 350 can urge the faces 332, 334 and 342, 344 together with a controlled force.

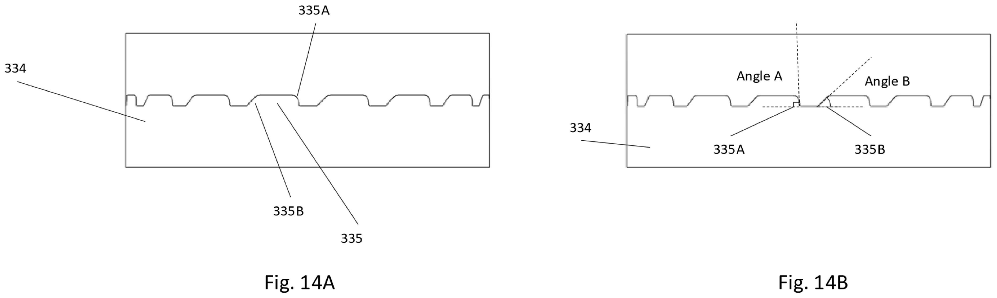

The Hirth joint on the mating surfaces 332, 342, 334, 344, can utilize asymmetrical Hirth joint teeth 335, having a first edge 335A and a second edge 335B. The teeth 335 of the Hirth joint, which can be arranged in a circle about the joint, can utilize two different angles. Angle A for first edge 335A can be about 90 degrees; angle B for second edge 335B can be about 45 degrees. Although specific angles are described, any suitable angle can be used for angle A and/or angle B. The teeth 335 in FIGs. 14A and 14B appear to change length because the view is a profile view of a circular object. However, the teeth 335 are disposed radially evenly around the circular joint and do not change length.

The rotation of the joint 313 requires the user to overcome the force of the spring 350 pushing the two mating surfaces 332, 334 and 342, 344 together. The teeth 335 are asymmetric, in one direction. That is, the first edge 335A of the teeth 335 are cut at a steep angle (angle A), making the force required to rotate the joint large. In the opposite direction, the second edge 335B of the teeth 335 are cut at a shallow angle (angle B), making the force required to rotate the joint small. The force required to move the joint is proportional to the sine of the teeth angle. Such a configuration can be more compact and can provide an asymmetrical rotation force. Particularly, a low force can be required to position the support 300 against the patient, but a high force can be required to open the support 300, thus providing sufficient force to hold the coil 1 against the patient.

Although certain connections for pivot points 113 are described, as noted above, the pivot points 113 can use any suitable connection which provides the movable, but rigid connection described above. For example, a friction fit can be used, wherein sufficient friction between corresponding mating surfaces 132, 142, 134, 144 maintains a particular position. Movement of the links 110 can be initiated by applying enough force to overcome the friction. A friction fit arrangement can allow links 110 to sit at any angle with respect to one another. As another example, a lock-unlock mechanism can be used, where the position is adjusted by unlocking the pivot points 113. This can be accomplished, for example, by positive detent pins, interlocking gears, or linkages. A user can actuate a trigger (or lever, knob, or other suitable feature) causing the pivot points 113 to move freely until a desired position is obtained. Actuating or releasing the trigger can freeze all the links 110 simultaneously.

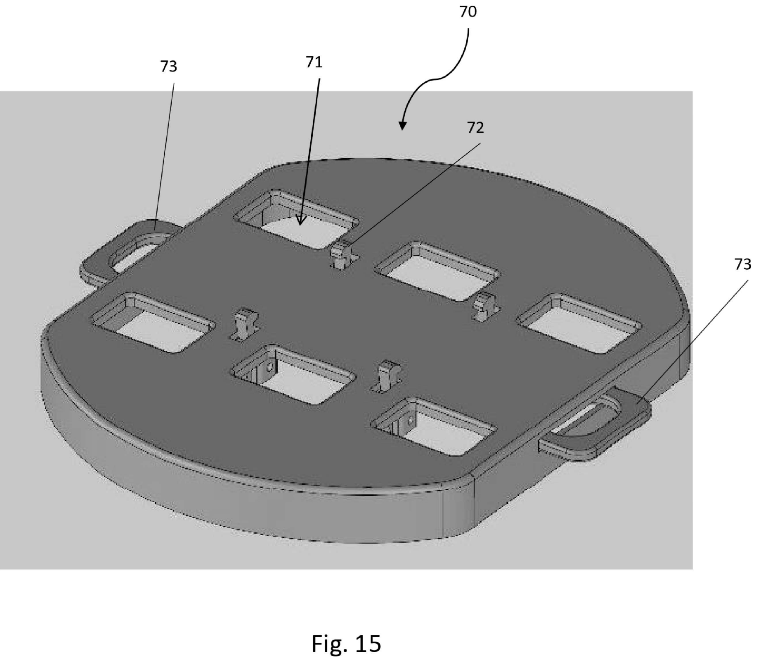

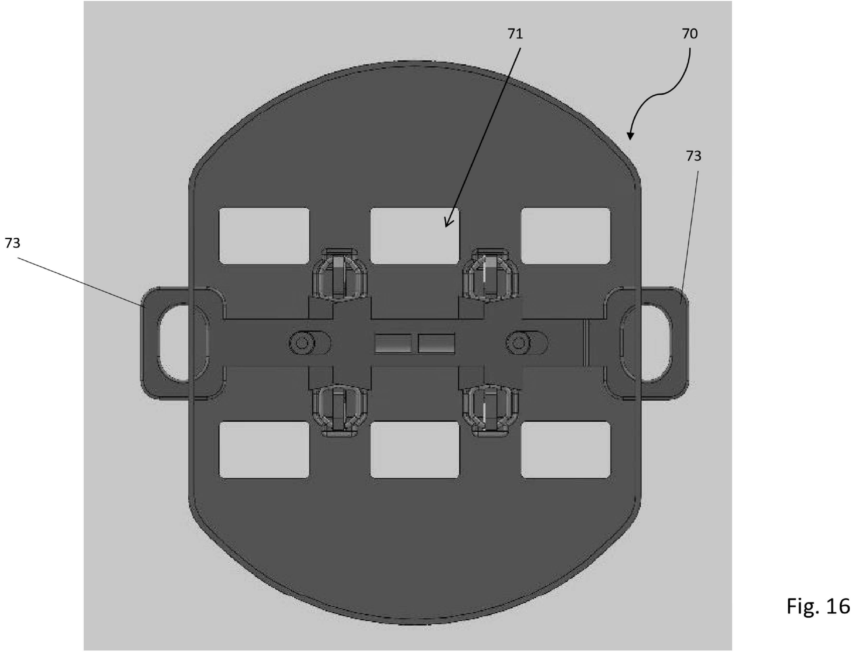

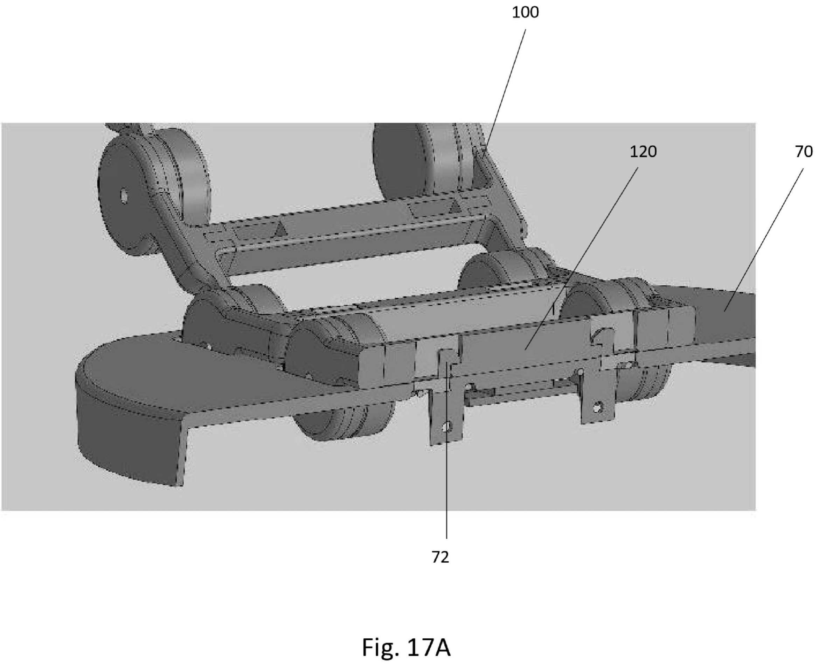

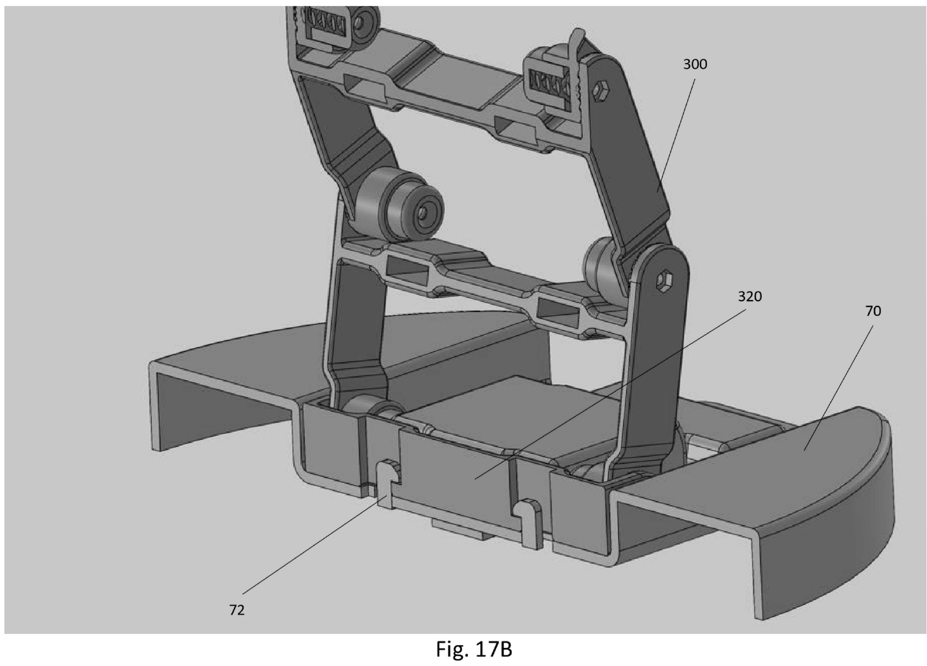

Regardless of the configuration of the links 110, 210, 310 and referring to FIGs. 15-22 for purpose of illustration and not limitation, a base 70 can be provided. Although the base is described with respect to support 100, the base can be used with support 200, 300 or any suitable support configurations. The base 70 can include one or more holes 71, which can act as receptacles for one or more portions of the flexible support 100. For example, the support 100 can drop into the holes 71 of base 70. Base 70 can include a hook system including a plurality of hooks 72, which can engage the links 110, for example, at the cross bar 120, as shown in FIGs. 17A-B. Release levers 73 can be coupled to the hooks 72, such that pulling on the lever 73 in either the left or right direction can spread the hooks 72 and release the support 100. Hooks 72 can latch to support 100 in any suitable manner. Additionally, any suitable number of latches can be used. As another example, a friction fit can be used to maintain the position of support 100. In such a configuration, release levers 73 are not required on base 70. Although a particular configuration is described, any suitable configuration of coupling the support 100 to base 70 is contemplated.

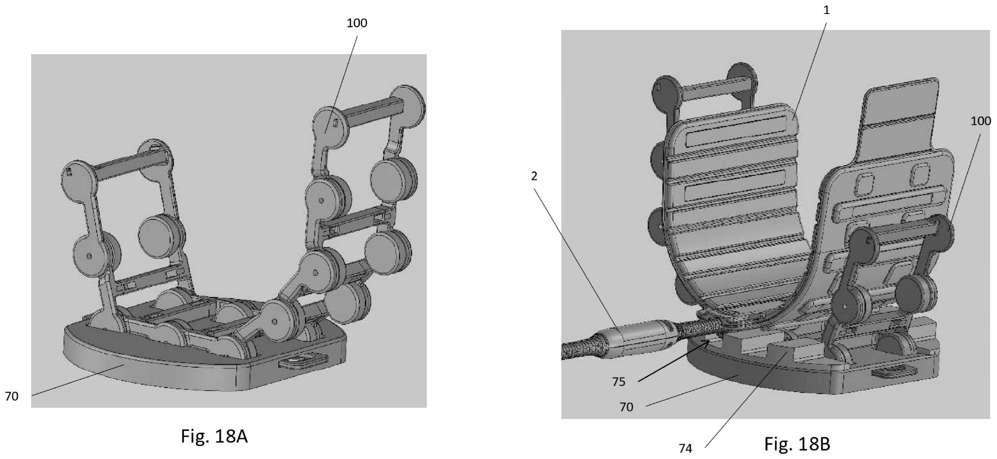

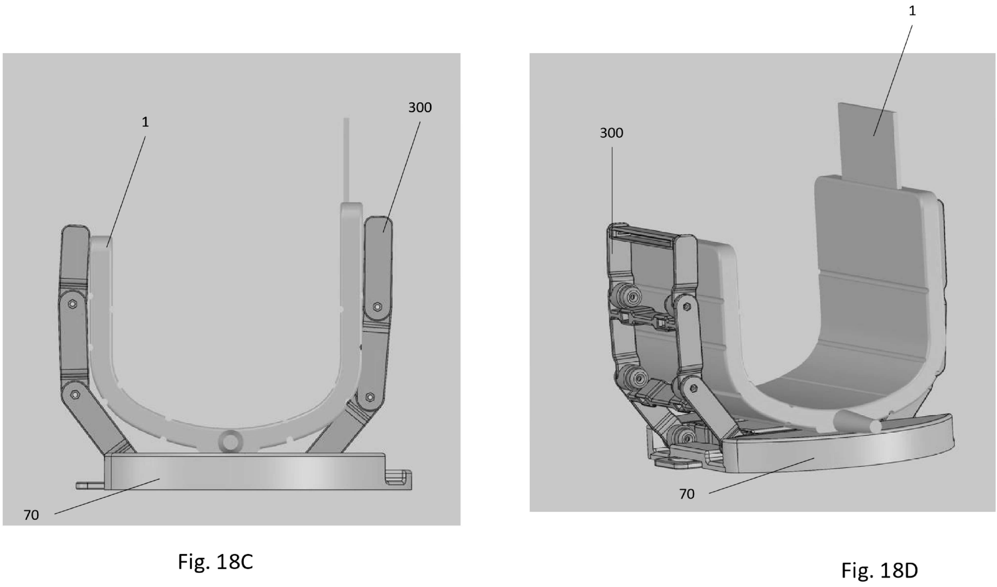

The support 100 can be placed on the base 70 in a plurality of positions relative to the base 70. For example, the support 100 can be centered on the base, thus forming a U-shape (FIGS. 18A-D), which can be useful, for example, for knee or ankle imaging. As another example, the support 100 can be placed such that an end of the support 100 is positioned on the base 70, thus forming a C-shape (FIGs. 19A-D), which can be useful, for example, for shoulder or elbow imaging. FIGs. 18B-D and 19B-D show the flexible support 100 disposed in the base 70 and supporting flexible coil 1 in U-shape and C-shape positions, respectively. As shown in FIGs. 18B and 19A, base 70 can include a support 74 with grooves 75, which can receive and/or guide coil cable 2. In accordance with the disclosed subject matter, the grooves 75 can be inversely matched with ridges in the flexible coil 1. Support 74 can be a pad constructed from urethane foam or other material. Alternatively, grooves 75 can be directly molded into the base 70. Base 70 can be molded of plastic.

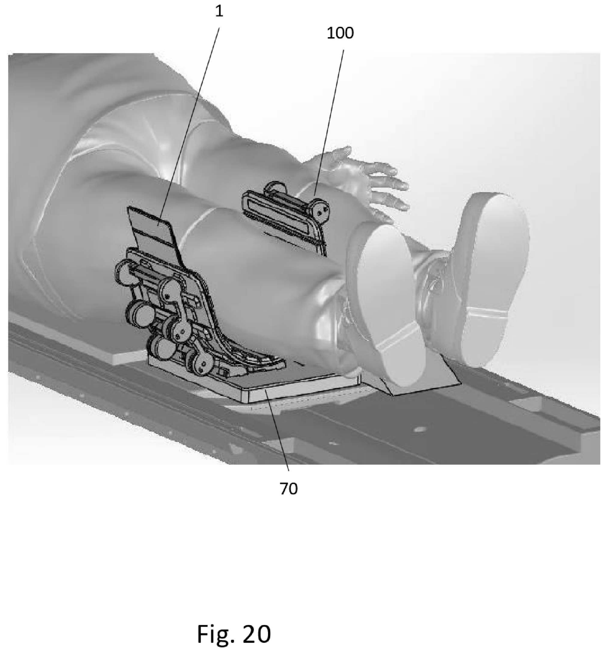

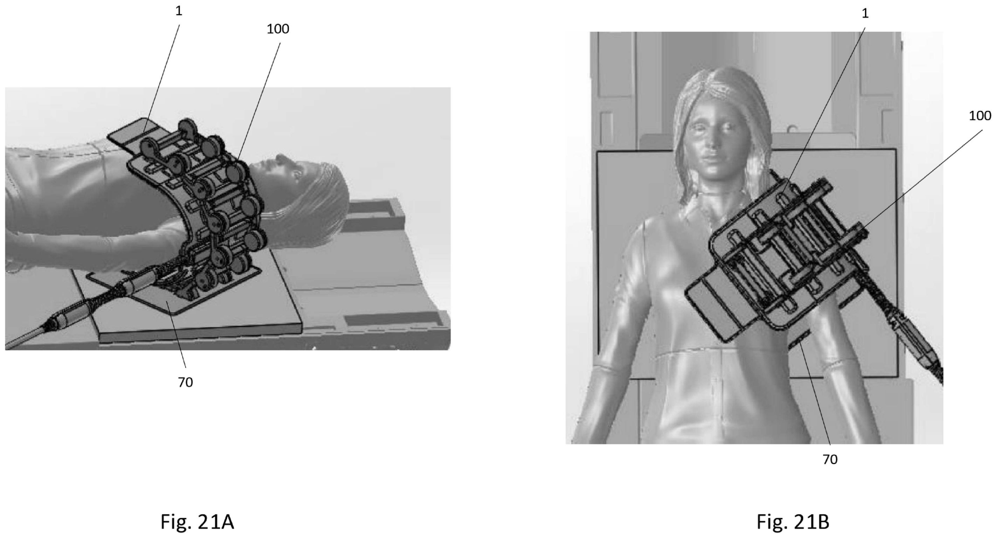

In operation, the base 70 can be positioned on a patient table. The flexible support 100 can be placed in the base. The arrangement of the flexible support 100 within the base can be selected based on the application. For example, for knee applications, the center links 110 can be placed in the holes 71 of base 70 (FIG. 20). As another example, for shoulder applications, the end links 111, 112, can be placed in the holes 71 of base 70 (FIGs. 21A-B). As another example, center links 110 and end links 111, 112 can be placed in the holes 71 of base 70. The flexible coil 1 can be placed on the support 100. The patient can then be positioned on the table, and the flexible support 100 can be moved to draw the flexible coil 1 close to the anatomy of interest. The flexible support 100 can be used to support a variety of flexible coils. For example, large flexible coils can be supported for imaging arm or torso sides.

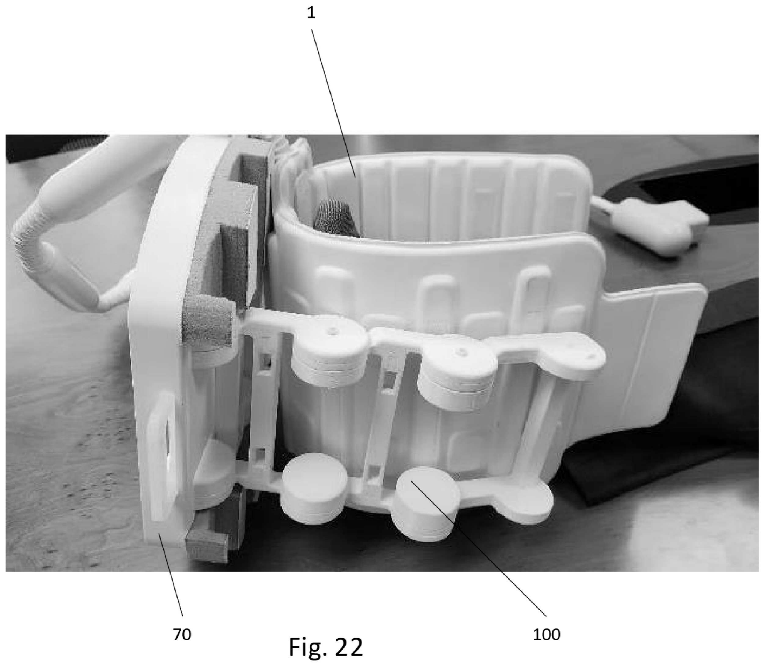

In accordance with the disclosed subject matter, base 70 can be configured to support the flexible support 100 in a vertical position. Such a configuration can be used for certain imaging applications, for example, foot imaging. The base 70 can support the flexible support 100 so that the flexible support 100 can be wrapped around the foot when the patient is in the supine positions, for example, as shown in FIG. 22. As another example, the base 70 can be configured such that it remains in a horizontal position on the patient table, but holes 71 can be configured to support the flexible support 100 in a horizontal position, for example, for use in foot imaging applications.

As with any device used in an MRI environment, all components of the adjustable support 100, 200 and base 70 must not contain ferromagnetic materials, and must be constructed from material which is MRI transparent. For example, materials that are MRI safe including non-ferromagnetic materials such as, plastic, fiberglass, composite materials, non-magnetic brass, phosphor bronze, or beryllium copper could be used.

The disclosed subject matter is also directed to a method of manufacturing a flexible support having some or all of the features described herein.

In addition to the specific embodiments claimed below, the disclosed subject matter is also directed to other embodiments having any other possible combination of the dependent features claimed below and those disclosed above. As such, the particular features presented in the dependent claims and disclosed above can be combined with each other in other possible combinations. Thus, the foregoing description of specific embodiments of the disclosed subject matter has been presented for purposes of illustration and description. It is not intended to be exhaustive or to limit the disclosed subject matter to those embodiments disclosed.

It will be apparent to those skilled in the art that various modifications and variations can be made in the method and system of the disclosed subject matter without departing from the spirit or scope of the disclosed subject matter. Thus, it is intended that the disclosed subject matter include modifications and variations that are within the scope of the appended claims and their equivalents.

## Claims

1. An adjustable support for a flexible receive coil, comprising:
a plurality of links including at least a first link, a second link, and a third link, each link having
a cross bar having a first-end portion and a second-end portion,
a first side bar coupled to the first-end portion of the cross bar and having
a first leading-end portion including a first leading-end mating surface, and
a first trailing-end portion including a first trailing-end mating surface,
a second side bar coupled to the second-end portion of the cross bar and having
a second leading-end portion including a second leading-end mating surface, and
a second trailing-end portion including a second trailing-end mating surface,
wherein the cross bar, first side bar, and second side bar define a coil-engagement surface; and
wherein the first link is rotatably coupled to the second link such that
the first leading-end portion of the first link is rotatably coupled to the first trailing-end portion of the second link such that the first leading-end mating surface of the first link engages the first trailing-end mating surface of the second link,
the second leading-end portion of the first link is rotatably coupled to the second trailing-end portion of the second link such that the second leading-end mating surface of the first link engages the second trailing-end mating surface of the second link, and
the first link and the second link define an adjustable angle therebetween.

2. The adjustable support of claim 1, wherein the coil-engagement surface of each link comprises a coil attachment feature.

3. The adjustable support of claim 2, wherein the coil attachment feature comprises a first side of a hook-and-loop fastener configured to engage a second side of a hook-and-loop fastener of a flexible receive coil.

4. The adjustable support of any one of claims 1 to 3, wherein the first leading-end portion of the first link is rotatably coupled to the first trailing-end potion of the second link by a first ball-and-detent configuration and the second leading-end portion of the first link is rotatably coupled to the second trailing-end portion of the second link by a second ball-and-detent configuration.

5. The adjustable support of any one of claims 1 to 3, wherein the first leading-end portion of the first link is rotatably coupled to the first trailing-end potion of the second link by a friction fit and the second leading-end portion of the first link is rotatably coupled to the second trailing-end portion of the second link by a friction fit.

6. The adjustable support of any one of claims 1 to 3, wherein the first leading-end mating surface of the first link comprises a plurality of gears configured to engage a plurality of gears disposed on the first trailing-end mating surface of the second link and the second leading-end mating surface of the first link comprises a plurality of gears configured to engage a plurality of gears disposed on the second trailing-end mating surface of the second link.

7. The adjustable support of any one of claims 1 to 6, further comprising a support base configured to receive at least one link.

8. The adjustable support of claim 7, wherein the support base further comprises a latch configured to releasably engage at least one cross bar.

9. The adjustable support of claim 7 or 8, wherein the support base further comprises at least one cable-receiving groove.

10. The adjustable support of any one of claims 1 to 9, wherein each link comprises a non-ferromagnetic material.

11. The adjustable support of any one of claims 1 to 10, wherein the second link is rotatably coupled to the third link such that the first leading-end portion of the second link is rotatably coupled to the first trailing-end portion of the third link such that the first leading-end mating surface of the second link engages the first trailing-end mating surface of the third link, the second leading-end portion of the second link is rotatably coupled to the second trailing-end portion of the third link such that the second leading-end mating surface of the second link engages the second trailing-end mating surface of the third link, and the second link and the third link define an adjustable angle therebetween.

12. The adjustable support of any one of claims 1 to 11, further comprising a first end link having
a cross bar having a first-end portion and a second-end portion;
a first side bar coupled to the first end portion of the cross bar and having
a first leading-end portion including a first leading-end mating surface, and
a first trailing-end portion;
a second side bar coupled to the second-end portion of the cross bar and having
a second leading-end portion including a second leading-end mating surface, and
a second trailing-end portion;
wherein the end link is rotatably coupled to the first link such that
the first leading-end portion of the end link is rotatably coupled to the first trailing-end portion of the first link such that the first leading-end mating surface of the end link engages the first trailing-end mating surface of the first link, and
the second leading-end portion of the end link is rotatably coupled to the second trailing-end portion of the first link such that the second leading-end mating surface of the end link engages the second trailing-end mating surface of the first link.
